(19) Europäisches Patentamt
European Patent Office
Office européen des brevets

(11) **EP 2 481 074 B1**

(12) **EUROPEAN PATENT SPECIFICATION**

(45) Date of publication and mention
of the grant of the patent:
**17.10.2018 Bulletin 2018/42**

(51) Int Cl.:
*H01J 37/32* *(2006.01)*    *G01R 19/00* *(2006.01)*

(21) Application number: **10759609.0**

(86) International application number:
**PCT/EP2010/063703**

(22) Date of filing: **17.09.2010**

(87) International publication number:
**WO 2011/036103 (31.03.2011 Gazette 2011/13)**

(54) **APPARATUS AND METHOD FOR MEASURING PLASMA PARAMETERS**

VORRICHTUNG UND VERFAHREN ZUR MESSUNG VON PLASMAPARAMETERN

APPAREIL ET PROCÉDÉ DE MESURE DE PARAMÈTRES PLASMA

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **22.09.2009 IE 20090733**

(43) Date of publication of application:
**01.08.2012 Bulletin 2012/31**

(73) Proprietors:
• **O'Sullivan, Donal**
  **Clonsilla, Dublin 15 (IE)**
• **Scullin, Paul**
  **Lucan, Co Dublin (IE)**

(72) Inventors:
• **O'Sullivan, Donal**
  **Clonsilla, Dublin 15 (IE)**
• **Scullin, Paul**
  **Lucan, Co Dublin (IE)**

(74) Representative: **FRKelly**
  **27 Clyde Road**
  **Dublin D04 F838 (IE)**

(56) References cited:
**US-A- 5 936 413    US-B1- 7 413 672**

• **SOBOLEWSKI M A: "Measuring the ion current in electrical discharges using radio-frequency current and voltage measurements", APPLIED PHYSICS LETTERS, AIP, AMERICAN INSTITUTE OF PHYSICS, MELVILLE, NY, US, vol. 72, no. 10, 9 March 1998 (1998-03-09) , pages 1146-1148, XP012019759, ISSN: 0003-6951, DOI: DOI:10.1063/1.121032**
• **SOBOLEWSKI MARK: "Real-time, noninvasive monitoring of ion energy and ion current at a wafer surface during plasma etching", JOURNAL OF VACUUM SCIENCE AND TECHNOLOGY: PART A, AVS /AIP, MELVILLE, NY., US, vol. 24, no. 5, 21 August 2006 (2006-08-21), pages 1892-1905, XP012091195, ISSN: 0734-2101, DOI: 10.1116/1.2335862**
• **SOBOLEWSKI M A: "Electrical characteristics of argon radio frequency glow discharges in an asymmetric cell", IEEE TRANSACTIONS ON PLASMA SCIENCE, vol. 23, no. 6, December 1995 (1995-12), pages 1006-1022, XP002618352, IEEE, USA ISSN: 0093-3813, DOI: 10.1109/27.476490**
• **SOBOLEWSKI MARK: "Effects of wafer impedance on the monitoring and control of ion energy in plasma reactors", JOURNAL OF APPLIED PHYSICS, vol. 100, no. 6, 29 September 2006 (2006-09-29), pages 63310-063310, XP012090007, AMERICAN INSTITUTE OF PHYSICS. NEW YORK, US ISSN: 0021-8979, DOI: 10.1063/1.2353203**

- SOBOLEWSKI MARK A: "Monitoring sheath voltages and ion energies in high-density plasmas using noninvasive radio-frequency current and voltage measurements", JOURNAL OF APPLIED PHYSICS, vol. 95, no. 9, 1 May 2004 (2004-05-01), pages 4593-4604, XP012067831, AMERICAN INSTITUTE OF PHYSICS. NEW YORK, US ISSN: 0021-8979, DOI: 10.1063/1.1687975

- SOBOLEWSKI MARK A: "Measuring the ion current in high-density plasmas using radio-frequency current and voltage measurements", JOURNAL OF APPLIED PHYSICS, vol. 90, no. 6, 15 September 2001 (2001-09-15), pages 2660-2671, XP012054114, AMERICAN INSTITUTE OF PHYSICS. NEW YORK, US ISSN: 0021-8979, DOI: 10.1063/1.1390491

**Description**

**Technical Field**

This invention relates generally to the field of plasma processing and more specifically to the field of in-situ measurement of plasma parameters, including ion flux, for process monitoring and control.

**Background Art**

Plasma processing systems are widely used to process substrates. Examples would be etching of silicon wafers in semiconductor manufacture and the deposition of layers in the manufacture of solar cells. The range of plasma applications is wide but includes plasma enhanced chemical vapour deposition, resist strip and plasma etch.

Plasma diagnostics to measure ion current or flow to a surface ($I_p$), electron temperature ($Te$,), Plasma electron density ($Ne$), Plasma resistance $Rp$, Plasma potential ($Vp$), Electron Energy Distribution Function ($EEDF$) and Ion Energy Distribution Function ($IEDF$) exist, the two main examples being the Langmuir probe, described in Langmuir Probe Measurements in the Gaseous Electronics Conference RF Reference Cell, M.B. Hopkins, J. Res. Natl. Inst. Stand. Technol. 100, 415 (1995), and the Retarding Field Energy Analyser, described in Design of Retarding Field Energy Analyzers, J. Arol Simpson, Rev. Sci. Instrum. 32, 1283 (1961).

These conventional diagnostic tools are limited to use in research applications in clean gases or with limited time in processing gases due to the deposition of weakly conducting material on the probes surface. The deposited layers reduce or remove the conduction current path on which the probes depend.

Until 1998 it was generally not possible to characterize a plasma process which used a complex gas other than by means of modelling. Specifically direct measurement of parameters such as the ion flow to a surface in etching and deposition plasmas was not possible during the process and so limited the deployment of sensors to monitor and control the process.

In US 5,936,413, the authors disclose a method for measuring an ion flow from a plasma to a surface in contact therewith, consisting of measuring the rate of discharge of a measuring capacitor connected between a radiofrequency voltage source and a plate-shaped probe in contact with the plasma.

The measurement method involves periodically supplying to a surface a train of radio frequency (RF) oscillations and performing a measurement between the two oscillation trains after the damping of the RF and before the potential on the surface returns to equilibrium. The method overcomes the issue of measuring a DC ion flow through a non-conducting layer and is therefore deployable in a real process reactor. However, the technique has a number of drawbacks.

A first disadvantage of the technique is the need to supply a sensor built into the electrode, wall or other part of the tool.

A second disadvantage of the technique is the need to supply a pulsed RF train that may perturb the plasma and adds a level of complexity to the deployment of the technique.

A third disadvantage is the technique cannot measure the ion flow directly on an RF biased substrate such as a silicon wafer as this would require an interruption to the process and add significantly to the cost and through put of wafers. The technique cannot be applied to a continuously biased substrate.

A fourth disadvantage is the technique needs to be applied to a special probe surface and the area of this surface is limited and the sheath may not be truly planar. The sheath may expand and collect ions at the edge. This becomes less of a problem for large area surfaces but applying an RF pulse to a large surface will need a large power input and may disturb the plasma. A guard ring may improve the situation but adds complexity and cost to the design.

US 6,326,794 describes a capacitance-based ion flux and ion energy probe based on two electrodes separated by an insulating layer. However, this device is suitable for processes where the conducting layers are exposed to the plasma. The deposition of insulating layers on the conducting surfaces exposed to the plasma will prevent the probe from measuring ion flux in a similar way to a Langmuir probe. It also requires a special probe inserted in the plasma.

US 6,339,297 describes a probe that measures the absorption of plasma waves from an RF wave launched by a probe. The technique measures plasma electron density. A major disadvantage is the need to insert a probe and the disturbance caused by the RF source needed, as well as the limited parameters that can be measured.

In 1998 M.A. Sobolewski published a technique for measuring the ion current at a semiconductor wafer that is undergoing plasma processing, see Measuring the ion current in electrical discharges using radio-frequency, current and voltage measurements, M. A. Sobolewski, Appl. Phys. Lett., Vol. 72, No. 10, 9 March 1998.

Sobolewski's technique relies on external measurements of the radio-frequency RF current and voltage at the wafer electrode. The RF signals are generated by the RF bias power which is normally applied to wafers during processing.

The $I(t)$ waveform is the sum of several currents, which can be expressed as

$$I(t) = -Ip + Ie(v_{max})Exp((v(t)- v_{max})/Te) + C(t)\, dv/dt \qquad \textbf{Eq. 1}$$

where:

$I(t)$ is the time dependent current measured at the electrode
$v(t)$ is the time dependent voltage measured at the electrode
$Ip$ is the dc ion current to the surface of the wafer
$v_{max}$ is the maximum value of $v(t)$
$Ie(v_{max})$ is the thermal electron current to the wafer at $v_{max}$
so that $Ie(v_{max}) = I(v_{max})-I(v_{min})$ where $v_{min}$ is the minimum value of $v(t)$.
$v(t)$ is the time dependent voltage at the wafer electrode
$C$ is the capacitive component of the plasma impedance.

The capacitive component C is time dependent and depends on the voltage $v(t) - v_{max}$.

The first term on the right hand side of equation 1 is the ion current. It is negative, corresponding to a flow of positive ions from the plasma to the electrode. The second term is the electron current, for a Maxwell-Boltzmann distribution of plasma electrons at temperature $Te$ in volts. The final term is the sheath displacement current which assumes the sheath and bulk plasma can be represented by a voltage dependent capacitor.

When the voltage $v(t)$ is negative, electrons in the plasma are strongly repelled from the electrode by the negative DC bias, and the electron current in Eq. 1 will be negligibly small. Furthermore, when $dv/dt = 0$, the charging current is zero.

Therefore, at the time $t_o$, when $v(t)$ reaches its minimum value, both the electron current and the charging current are negligible. The value of the current waveform at that time is therefore equal to the ion current, $I(t_o) = I_o = -Ip$.

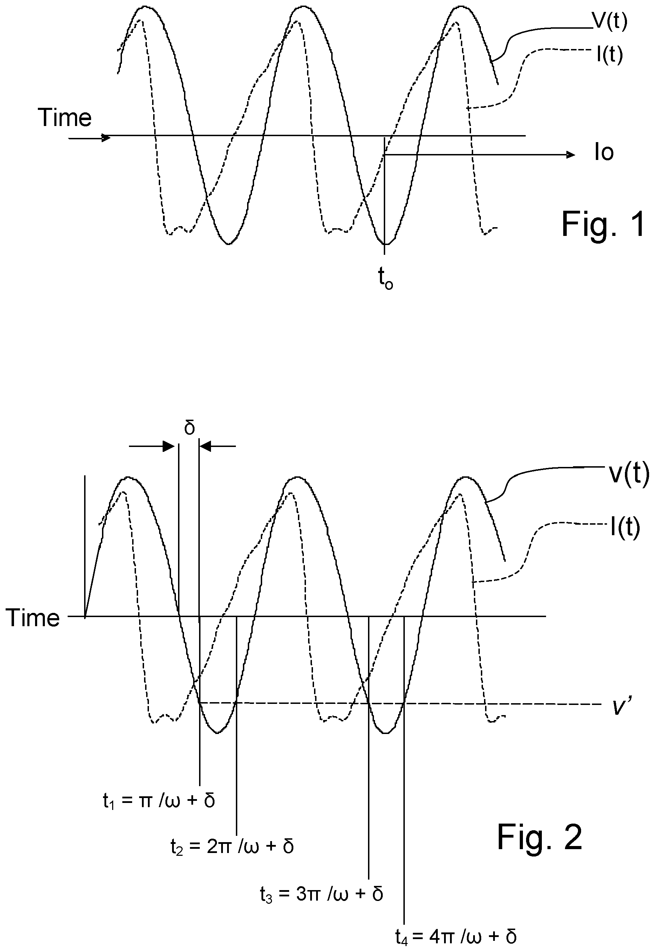

Fig. 1 shows the $I(t)$ and $v(t)$ signals from an RF biased plasma electrode and the Sobolewski method to extract Io. Thus, the ion current can be determined using very general arguments, with no need for a detailed model of the displacement current or the electron current.

The Sobolewski paper represented a breakthrough in that he showed that the ion current, which is a dc current, could be measured through a non conducting dielectric, but in practice the technique proposed by Sobolewski has two major drawbacks limiting its implementation in real process plasma.

The first and most significant is that the time window to measure $I_o$ is small and any inaccuracy in the measurement of $t_o$ causes a significant error in the value of $I_o$. Second, in this technique it is assumed that any resistive component caused by electron collisions is ignored. This assumption does not apply to many process plasmas.

In general the technique requires advanced electronics to capture the waveforms to the resolution required which adds significantly to the cost.

## Disclosure of the Invention

There is provided a method of measuring ion current between a plasma and an electrode in communication with said plasma, wherein a time-varying voltage is measured at said electrode and a time-varying current through said electrode is measured, the method comprising the steps of:

(a) recording, for each of a plurality of voltage values, $v'$, a plurality, $n$, of current values I($v'$); and
(b) obtaining from said current and voltage values a value of said ion current; wherein:

said electrode is insulated from said plasma by an insulating layer, such that said current values lack a DC component; and
said step of obtaining a value of said ion current comprises performing a mathematical transform effective to:

(i) express said current and voltage values as a relationship between the real component of current through said electrode and the voltage by obtaining an average of the current values measured for each of the plurality of discrete voltage values, thereby eliminating a capacitive contribution to the current through the electrode;
(ii) isolating from said real component of current through the electrode an isolated contribution attributable to an ion current and a resistive term, said contribution being free of any electron current contribution;
(iii) determining from said isolated contribution a value of ion current.

The justification for this method will be discussed below in greater detail. However, one may note that this method is designed to work for an electrode which is in series with the plasma through an insulating layer and which thus has no net conduction current, whereas a Langmuir probe depends on a conduction current path. A Langmuir probe loses accuracy when the surface of the probe becomes shielded by deposition of weakly conducting or insulating material, whereas this method is designed to work with an electrode shielded from the plasma by an insulator.

While there is no net conduction current through such an insulator, we have discovered that there is nevertheless a real current flow, and it is possible to measure a current-voltage transfer function for that current. It is further possible to confine measurements to exclude any current flow attributable to an electron current, and thereby find a linear relationship between the real current-voltage transfer function and the ion current flowing across the plasma sheath layer and through the resistive plasma. The contribution attributable to an electron current may be eliminated for example by choosing, where the amplitude of v' greatly exceeds the electron temperature expressed in units of voltage, only measurements where v' < 0 or by noting that, in the frequency domain, this electron current approximates a delta function, which provides a constant contribution at all frequencies; by subtracting such a constant found across all frequencies, one can eliminate the current flow attributable to electron current.

Preferably, said step of isolating a contribution attributable only to ion current and a resistive term comprises determining a threshold voltage below which electron current is inhibited, and isolating a set of current values corresponding to a set of voltage values below said threshold.

Preferably, said step of determining from said isolated contribution a value for the ion current, Ip, comprises solving, for values of v' less than said threshold, the equation:

$$\Sigma\, I(v') \,/\, n = -Ip \;+\; v'\, Rp/\, |z|\ ,$$

where:
Rp is the plasma resistance,

$$|z| = \{\, Rp^2 \;+\; (1/\, \omega C(t))^{\,2}\, \},$$

$\omega = 2\pi f$, where f is the frequency of the RF voltage on the electrode, and C(t) is the time-dependent capacitive component of the plasma impedance.

The method may also comprise the step of calculating the resistive term Rp/|z| as a solution to the same equation: $\Sigma I(v')/n = -Ip + v'Rp/|z|$. In cases where the resistive term only is required, the equation can simply be solved for that term and not for the ion current.

Preferably, the time-varying voltage is a sinusoidal voltage applied to said electrode.

Further, preferably, said plurality, *n,* of current values I(v') measured for each of a plurality of voltage values, *v',* include approximately *n*/2 values measured where the voltage is increasing and approximately *n*/2 values measured where the voltage is decreasing.

In this way a capacitive-dependent element of the relationship can be ignored for values of v' < 0 since this capacitive-dependent element changes sign with dv/dt, so that by taking large numbers of measurements, approximately half of which are measured with positive dv/dt and half with negative dv/dt, the capacitive terms cancel one another out when the values are averaged for all n.

Preferably, the voltage is a periodically varying voltage and said current values I(v') are measured at times which are uncorrelated with the period of the voltage.

Put another way, the method can be carried out by taking large numbers of current measurements at random times with respect to the time-varying voltage, so that statistically one will collect enough measurements for each value v' to ensure roughly equal numbers of increasing-voltage and decreasing-voltage values, as well as providing a highly accurate average current for each voltage value.

The method may further include the steps of:

(d) calculating the thermal electron current at vmax, Ie(vmax) as the difference between the average current *ΣI(vmax)/n* measured at a maximum voltage value vmax, and the current extrapolated from the linear equation for current as a function of v', for v' <0, in accordance with the equation:

$$Ie(vmax) = (\Sigma\, I(vmax)/n + Ip - \;vmax\, Rp/|z|);$$

and
(e) calculating, for values of v' > 0, the electron temperature Te from the equation:

$$(\Sigma\, I(v') \,/\, n + Ip - v'\, Rp/|z|\,) \,/\, Ie(v_{max})\ =\ Exp((v'- v_{max}\,)/Te).$$

It will be appreciated that in this equation the terms Ip and Rp/|z| are preferably derived in accordance with the methods set out herein. However, it is also possible to carry out the electron temperature calculation as above without having used the methods disclosed here for calculation of Ip and Rp/|z|. It is also possible, as outlined in further detail below, to carry out an operation in the frequency domain which arrives at the same result.

Preferably, the method further comprises the step of:
determining, from the equation $Sqrt([I(v') - \Sigma(v')/n]^2) = \omega v'/\{C(v')\omega^2|z|\}$, the voltage-dependent capacitance, C(v').

This then allows one to solve the equation:

$$C(t) = \varepsilon A/7411\ \sqrt{\{Ne/(v(t)-Vp)\}}$$

to obtain the electron density, Ne, and the plasma potential, Vp, where A is the electrode area and $\varepsilon$ is the permittivity of free space, in MKS units.

Which is equivalent to solving:

$$C(v') = \varepsilon A/7411\ \sqrt{\{Ne/(v'-Vp)\}}$$

This can be solved in conjunction with the equation

$$(\Sigma\, I(v') \,/\, n + Ip - v'\, Rp/|z|\,) \,/\, Ie(v_p)\ =\ Exp((v'- p\,)/Te).$$

Knowing that Ie(Vp) is the thermal flux of electrons at the plasma potential,

$$Ie(Vp) = \tfrac{1}{4}\, e\, Ne\, Vth\, A$$

where Vth is the thermal velocity = $\sqrt{(8Te\, e/\pi Me)}$, A is the area of the electrode and Me is the mass of the electron and e is the electronic charge. Te is in units of Volts.

The electron density and temperature determine the flux of current Ie(v') to an electrode. When Ie(v') is equal to the thermal flux to an unbiased electrode based on the measured value of Ne and Te then this value v' must equal Vp.

The general method outlined above may alternatively be carried out using Fourier transform methods, as will now be disclosed.

Preferably, said step of expressing said current and voltage values comprises performing a Fourier transform to obtain a series of Fourier components representing the real electrode current.

Preferably, said step of isolating a contribution attributable only to ion current and a resistive term comprises identifying within said series of Fourier components one or more components attributable only to an electron current and subtracting said one or more electron current components to leave a remainder attributable only to ion current and a resistive term.

Preferably, said step of determining from said isolated contribution a value for the ion current, Ip, comprises solving the equation for A0, the zeroth order Fourier coefficient: A0 = C1 - Ip = 0, where C1 is the magnitude of the second order Fourier coefficient.

There is also described a method of measuring ion current between a plasma and an electrode insulated from said plasma by an insulating layer, wherein a time-varying voltage is measured at said electrode and a time-varying current through said insulating layer is measured, the method comprising the steps of:

(a) recording, for each of a plurality of voltage values, v', a plurality, n, of current values I(v') at different times;
(b) calculating, for each of said plurality of discrete voltage values v', the real current-voltage transfer function $\Sigma I(v')/n$; and
(c) identifying, from said real current-voltage transfer function, a contribution comprising values attributable to ion current and not to electron current;
(e) calculating from said identified contribution a value for the ion current.

There is further described a method of measuring ion current between a plasma and an electrode insulated from said plasma by an insulating layer, wherein a time-varying voltage is measured at said electrode and a time-varying current through said insulating layer is measured, the method comprising the steps of:

(a) determining the real time-dependent current as a function of the time-varying voltage;
(c) transforming said function into a frequency domain to generate a plurality of different frequency components;
(d) identifying among said frequency components a contribution attributable to ion current and not to electron current;
(e) calculating from said identified contribution a value for the ion current.

All of the methods above are preferably carried out by a suitably programmed computer which may be a general purpose computer or a dedicated machine.

Therefore, there is also provided a computer program product according to claim 14.

There is also provided an apparatus for measuring ion current between a plasma and an electrode insulated from said plasma by an insulating according to claim 15.

Mathematical justification: measurement of ion current and plasma resistance

It will be recalled that Eq. 1 was the Sobolewski equation, which had certain inaccuracies. A more accurate equation which contains a resistive component and a sheath capacitance and can be more widely applied to an RF biased electrode in a plasma is (using the same notation as Eq. 1):

$$I\,(t) = -Ip \; + \; Ie(v_{max})\, Exp((v(t) - v_{max})/Te) + v(t)\,Rp/\,|z| + dv(t))/dt\,/\{C(t)\omega^2|z|\} \qquad \textbf{Eq. 2}$$

Where

$$|z| = \{\,Rp^2 \; + \; (1/\,\omega C(t))^{\,2}\,\}$$

$Rp$ = the plasma resistance in series with the sheath capacitance.
$\omega = 2\pi f$, where f is the frequency of the RF voltage on the electrode.

In Eq. 2, which simplifies to Eq. 1 when Rp is zero, $I_o$ now contains Ip and the resistive term $v(t)Rp/|z|$ and the Sobolewski method does not work.

In Fig. 2 we show, in the case of a sinusoidal voltage, that at time $t_1 = \pi/\omega + \delta$ the voltage equals v', where $\delta$ is a arbitrary time defined as $-\pi/(2\omega) > \delta < \pi/(2\omega)$. We also show that at $t_2 = 2\pi/\omega - \delta$ the voltage also equals v'.

In subsequent times the voltage v' only occurs at times equal to $t = n\pi/\omega - (-1)^n\,\delta$ where n is an integer which increments twice in each period. We also note that for all positive values of $\delta$ less than $\pi/(2\omega)$, then v' is negative so that no electrons are present. We can now construct a series of equations for n = 1 upwards using Eq.2 and ignoring the electron current.

$$\textbf{For n=1:}\qquad I\,(t1) = -Ip \; + v'\,Rp/\,|z| + v'\,C(t)/|z|\,\,|\,dv/dt|_{v=v'}$$

$$\textbf{For n=2:}\qquad I\,(t2) = -Ip \; + v'\,Rp/\,|z| - v'\,C(t)/|z|\,\,dv/dt|_{v=v'}$$

$$\textbf{For n=3:}\qquad I\,(t3) = -Ip \; + v'\,Rp/\,|z| + v'\,C(t)/|z|\,\,|\,dv/dt|_{v=v'}$$

$$\textbf{For n=4:}\qquad I\,(t4) = -Ip \; + v'\,Rp/\,|z| - v'\,C/|z|\,\,dv/dt|_{v=v'}$$

where $dv/dt|_{v=v'}$ is the magnitude of derivative of v with respect to t taken at v'.

As the capacitive term changes sign on alternate values of n then the mean value of the current over a large number of n will average to zero. Note that it is not necessary to take the measurements in sequence. Summing and averaging over n samples we see that:

$$\Sigma I(v') / n = -Ip + v' Rp/ |z| \quad \text{for v'} < 0 \qquad \textbf{Eq. 3}$$

If we take random samples of I(*v'*) and average the mean will tend to (-*Ip* + *v'Rp*/|*z*|), and this conclusion is valid for all values of δ with magnitude less than π/(2ω).

If we now define $\Sigma I(v')/n$ as the real current-voltage transfer function then once we determine $\Sigma I(v')/n$ we can solve a simple linear equation for v' < 0 to solve for Ip and the resistive plasma component *Rp*/|*z*|.

Mathematical justification: measurement of electron temperature

If electrons are present, then from Eq. 2 one can again construct a series of equations for each discrete voltage value *v'*, where *v'* > 0, in which the capacitive term changes sign on alternate values of n so that the mean value of the capacitive term over a large number of n will average to zero:

$$\Sigma I(v') / n = -Ip + Ie(v_{max}) Exp((v'- v_{max})/Te) + v' Rp/ |z| \quad \text{for v'} > 0$$

Rearranging one gets:

$$(\Sigma I(v') / n + Ip - v'Rp/|z| ) / Ie(v_{max}) = Exp((v'- v_{max})/Te), \ \text{for v'} > 0 \qquad \textbf{Eq. 4}$$

The left hand side of Eq 4 can be found having determined Ip and *Rp*/|*z*| as shown above or in some other way. By taking the log of both sides we have a simple linear equation from which to determine Te.

Because $\Sigma I(v')/n$ is the average of all measurements, very high signal to noise ratios can be achieved as the number of samples is increased. The S/N ratio will increase linearly with the square root of the number of samples. It is not required that complex waveforms are recorded or that the sample frequency is higher than the RF frequency allowing for a simple low cost solution where that is required.

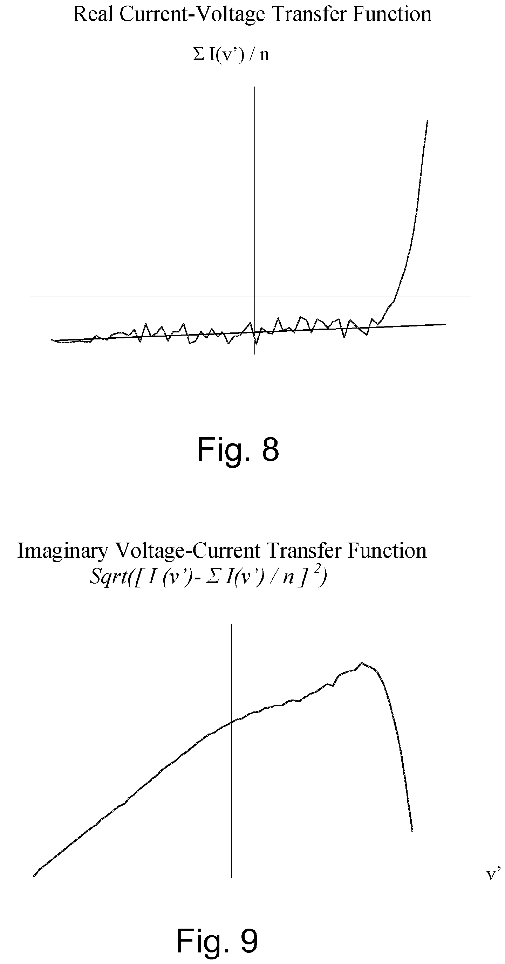

Fig. 8 shows a plot of the real current-voltage transfer function $\Sigma I(v')/n$ against v', for the data plotted in Fig. 1. It is also possible to determine the imaginary current voltage transfer function. We also note that the displacement current Ic(t) = I(t) - $\Sigma I(v')/n$ and that we can remove the time dependence to produce Irms (v') which equals the mean of the square root of Ic(t) squared at each value of voltage v'.

Fig. 9 shows a plot of the imaginary current-voltage transfer function for the data plotted in Fig. 1. As the displacement current is mainly due to sheath capacitance, we can determine the capacitance and its non-linearity with respect to voltage.

Determination of electron current, electron density and plasma potential

The capacitive term is cancelled out when we determine the real current voltage characteristic. As the displacement current is mainly due to sheath capacitance, we can determine the capacitance and its non-linearity with respect to voltage.

The voltage across the sheath is relative to the plasma potential, Vp. And its capacitance is related to the sheath width, d and the area of the electrode A. We also note that ε is the permittivity of free space.

$$C(t) = \varepsilon A/d \approx \varepsilon A/ ( \lambda_d (v(t)-Vp)/Te)^{1/2}) = \varepsilon A/7411 \sqrt{\{Ne/(v(t)-Vp)\}} \text{ in MKS units. } \textbf{Eq. 5}$$

From Eq. 2 and Eq. 3 we note that

$$I (v')- \Sigma I(v') / n = dv(t)/dt /\{C(t)\omega^2 |z|\}$$

The term on the right changes sign so that if we obtain the root mean square value

$$Sqrt([ I (v')- \Sigma I(v') / n ]^2) = \omega v' /\{C(v')\omega^2 |z|\}$$

We call the average value of $Sqrt([I(v')-\Sigma I(v')/n]^2)$ taken over many samples the imaginary voltage-current transfer function and we can determine the voltage (or time) dependant capacitance C(v') from this function for a sinusoidal voltage.

From Eq. 3, we can obtain the resistive term $Rp/|z|$ (let us denote this as $A = Rp/|z|$).

From Eq. 5, we can obtain the capacitive term $1/\{C(v')\omega|z|\}$ (let us denote this term by the function $B(v')= 1/\{C(v')\omega|z|\}$).

So that:

$$Rp = A|z|$$

$$1/\{C(v')\omega\} = B|z| \quad \dots \text{ (for clarity the dependence on v' is omitted)}$$

$$|z| = (A|z|)^2 + (B|z|)^2 \quad \dots \text{ (by definition)}$$
$$= 1/(A^2 + B^2)$$

Once $|z|$ is known we can find C(v') and Rp. Once C(v') is known we can use Eq. 5 to solve for Ne and Vp.

Furthermore, the electron current Ie, as a function of voltage in a Maxwellian approximation is known when Ne, Te and Vp are known. We can use Eq. 4 to verify values of Vp, Ne by extrapolating Eq4 to Vp. In this way all the key plasma parameters can be determined from the real and imaginary voltage current transfer functions.

Because $\sum I(v')/n$ is the average of all n measurements, very high signal-to-noise ratios can be achieved as the number of samples is increased. The S/N ratio will increase linearly with the square root of the number of samples. It is not required that complex waveforms are recorded or that the sample frequency is higher than the RF frequency allowing for a simple low cost solution where that is required.

There is further provided a method of calculating the electron current $I_e$ by determining a log-linear relationship for said real current-voltage transfer function for values of v' > 0, and extrapolating said linear relationship to determine the resulting current $I_e$ at the plasma potential Vp.

**Brief Description of the Drawings**

Fig. 1 shows the I(t) and v(t) signals from an RF-biased plasma electrode and the Sobolewski method to extract Io;
Fig. 2 again shows the I(t) and v(t) signals from an RF-biased plasma electrode, and illustrates the voltage v' measured at the times satisfying $t = n\pi/\omega - (-1)^n\delta$;
Fig. 3 is a schematic diagram of a first sensor for use in measuring a current-voltage characteristic;
Fig. 4 is a schematic diagram of a sensor array embedded in a placebo wafer;
Fig. 5 is a schematic diagram of a first apparatus for measuring plasma parameters;
Fig. 6 is a schematic diagram of a second apparatus for measuring plasma parameters;
Fig. 7 is a schematic diagram of a third apparatus for measuring plasma parameters;
Fig. 8 is a plot of the real current-voltage transfer function, $\sum I(v')/n$, for the data shown in Fig. 1; and
Fig. 9 is a plot of the imaginary current-voltage transfer function,

Sqrt $([I(v') - \sum I(v')/n]^2)$, for the data shown in Fig. 1.

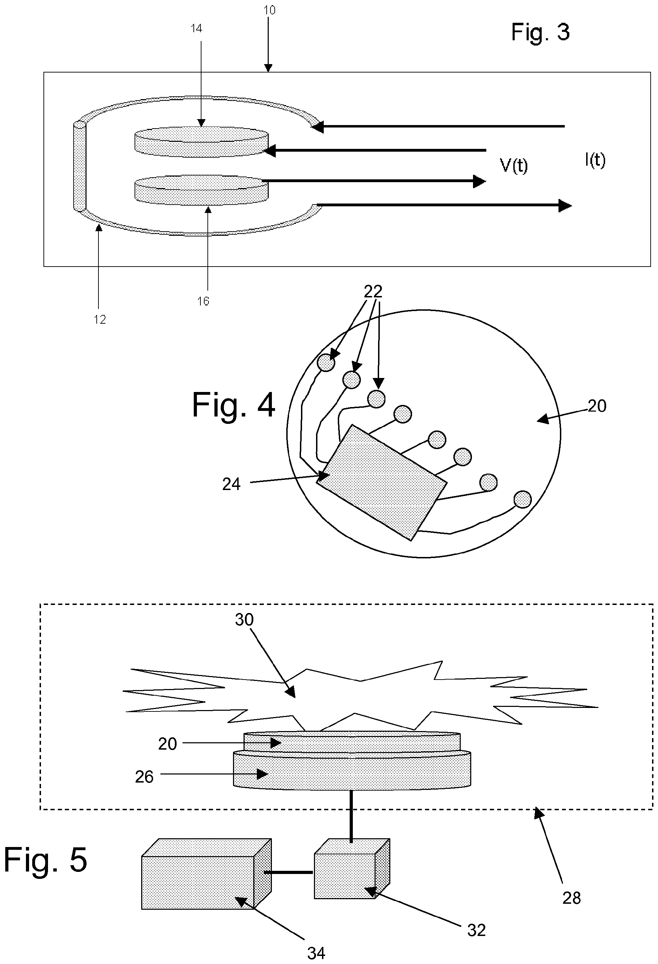

Fig. 3 shows a schematic diagram of a first sensor for use in measuring a current-voltage characteristic. The sensor is a differential I-V sensor embedded in a dielectric material 10 such as ceramic, and comprises a pick-up loop 12 in which the induced current is proportional to a current between two conducting plates 14, 16 which are separated by a distance d along the lines of an applied E-field. The output of the sensor is calibrated at different frequencies to give accurate values of differential voltage and current.

In use the dielectric material with the embedded sensor is placed on the electrode in place of a substrate. An RF field is applied to the source electrode. The embedded sensor electrode is exposed to an RF bias. The coil and capacitive plates pick up the I(t) and V(t) signals, and these are converted to digital values for processing by the embedded sensor controller (Fig. 4).

Fig. 4 shows a "placebo wafer": a silicon wafer having similar dimensions and physical characteristics to a wafer used in a manufacturing process employing a plasma, for use in determining the parameters of that plasma. The placebo wafer 20 has embedded therein a plurality of I-V sensors 22 of the type illustrated in Fig. 3, all of which are connected to a control processor 24. An electrode with multiple probes can be used to measure the spatial evolution of plasma parameters across a region of interest such as the surface of a wafer, or solar panel or other substrate.

The control processor is integrated with a storage medium for capturing the output of the individual sensors for later analysis when the placebo wafer is removed from the plasma process.

The control processor performs the following main functions;

a) Data sampling and conversion, where the I(t) and V(t) signals from the multiple embedded sensors are sampled at a pre-determined sampling rate and converted to digital values which are stored in memory.

b) Digital Signal processing, where the converted I(v) and V(t) data points are processed using a digital Fourier transform, the output being a Fourier representation of the voltage current and relative phase of the measured signals.

c) Post processing, where the acquired data is averaged to improve signal to noise ratio.

d) Data formatting and storage, where the acquired data is suitably formatted and stored for transmission to the host software.

e) Transmission of the acquired data to the host software/program for presentation, monitoring and further analysis.

Fig. 5 illustrates the use of the placebo wafer of Fig. 4. The wafer 20 is placed on a chuck 26 which acts as an electrode. The chuck 26 and wafer 20 are within a plasma chamber 28 within which a plasma process 30 operates. A match unit 32 is connected to an RF power supply 34. The power supply drives a voltage at an RF frequency. The match unit matches the non-50 Ohm impedance of the plasma chamber to the 50 Ohm transmission line impedance of the RF power supply. The placebo wafer is exposed to the generated RF field. The sensors on the placebo wafer generate I(t) and V(t) signals at different positions along the wafer. These signals are processed by the embedded controller on the placebo wafer, where they are processed.

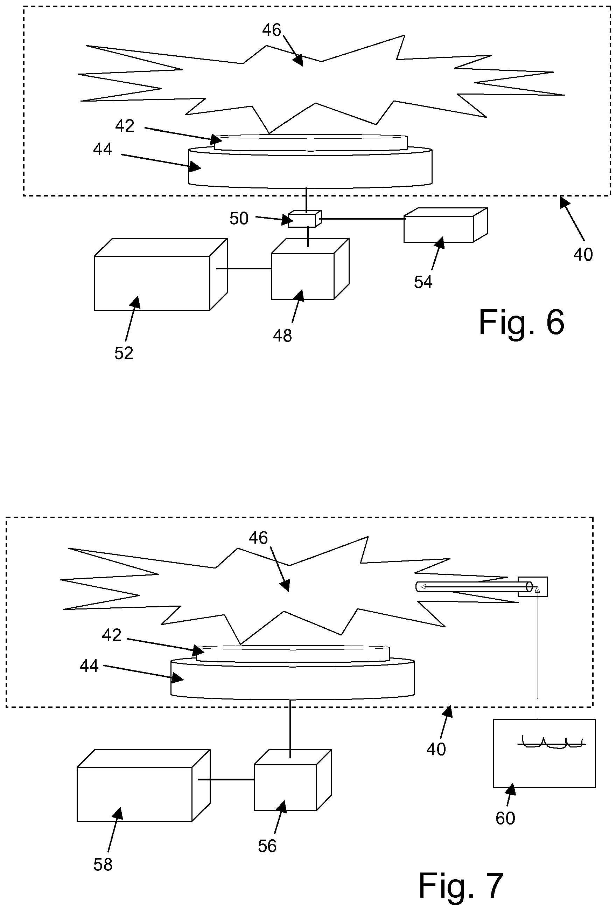

Figs. 6 and 7 show two further embodiments, in each of which there are certain common elements including a plasma chamber 40 in which a real process wafer 42 (in contrast to the placebo wafer of Figs. 4 and 5) is mounted on a chuck 44 and exposed to a plasma process 46.

In the Fig. 6 embodiment, a match unit 48 is connected between an I-V sensor 50 and an RF power supply 52. The sensor 50 is coupled to the chuck 44. The output from the sensor (providing the measured current as a function of applied voltage) is picked up by a data analysis and storage unit 54 which is connected to a computer (not shown) to perform analysis of the stored data and thereby calculate the plasma parameters.

In the Fig. 7 embodiment a match unit 56 is connected between an RF power supply 58 and the chuck 44. An arbitrary waveform generator 60 drives an I-V sensor unit 62 having embedded electronics and storage. The sensor unit 62 is coupled to a probe 64 extending into the plasma process. The measured I-V response from the sensor (providing the measured current as a function of applied voltage) is stored in the embedded storage which is connected to a suitably programmed computer (not shown) to perform analysis of the stored data and thereby calculate the plasma parameters, either in real time or as a later batch process.

It will be appreciated that the data can be wirelessly transmitted between components and that any suitably networked system can be substituted for a stand-alone computer, and that the distribution of components can take any suitable form. The computer can be replaced with a dedicated microprocessor, with hard-wired electronic circuitry, or with any other suitably programmed apparatus to perform the required data analysis and calculations.

A typical programmed data processing operation will now be described. The apparatus is controlled to apply a time-varying voltage to the sensor and to measure the resulting current arising picked up by the coil through the insulator of the sensor.

Measurements are taken of the voltage v(t) and the current I(v) on the electrode placed in the plasma. Current can be measured by means of an inductive pick-up and voltage by means of a capacitive pick-up. The I-V probe is calibrated over a broadband of frequencies typically to 10 times the fundamental of the applied RF voltage. The sampling rate of the I-V probe can be any suitable frequency and need not exceed the fundamental, reducing the cost of the system.

The sensor is calibrated in-situ to remove the effects of parasitic capacitance and resistance and to give a true value of the current and voltage at the electrode, taking into account transmission line effects between the location of the sensor and the electrode.

The recorded current at the electrode is continuously incremented into a current table in rank order with the measured voltage taken at the same time.

For example the Current rank table could contain entries for ranks from 0 - 100 for an applied voltage that has an amplitude of 50V peak (i.e. each rank covers an interval of 1 volt). A second Count table is used as an index to obtain the current average. If the voltage is 49.6 and the current .13 amps then the current is added to the rank 100 that is between 49 and 50 volts and the Count(100) entry is incremented by one. If the next measurement is -20 V and -.1A then -0.1A is added the 30th rank between -20 and -19 volts and the count index at location 30 (Count(30)) is incremented by one. This procedure continues at ideally the full sample rate until a measurement of ion flux is required.

Supposing the sample rate is 10 million samples per second and 10 measurements per second are required. At the end of 100ms the process would have added 1 million current values into the Current table with each location containing on average 10,000 measurements (the distribution will not be exactly uniform due to the sinusoidal variation in voltage which means that not more samples are collected towards the maximum and minimum voltages if the sample rate is uniform, but by collecting a number of samples there will still be an ample number collected for each voltage rank). The exact number of current measurements in each location of the Current table would be recorded in the count table. A new table, AvCurrent table is created by dividing each value of the Current table with the corresponding index table value AvCurrent (Vrank) = Current(Vrank)/Count(Vrank) for Vrank = 0 to 100.

During the negative part of the voltage cycle the electrode collects ion current and electrons are repelled as the voltage becomes more positive electrons are collected. Over the whole cycle the net current is zero as no net current flows in a capacitor.

Pseudocode implementation:

| | |
|---|---|
| inc = 1 | line 1 |
| For t = 0 to T | line 2 |
| Vmin = min(v(t)) | line 3 |
| Vmax = max(v(t)) | line 4 |
| i = integer((v(t)-Vmin)/inc) | line 5 |
| IR(i) = IR(i) + I(t) | line 6 |
| IC(i) = Ic(i) + 1 | line 7 |
| II(i) = II(i) + sqrt((I(t)-IR(i)/IC(i))^2) | line 8 |
| IE = IR((Vmax-Vmin)/int)/IC(Vmax-Vmin)/int)-IR(0)/IC(0) | line 9 |
| Then for i < (-Vmin/inc) | line 10 |
| Solve | line 11 |
| IR(i)/IC(i) = -Ip + (i*inc+Vmin) Rp/|z| | |
| To obtain A = Rp/|z| | line 12 |
| Then for i > (-Vmin/inc) | line 13 |
| Solve | line 14 |
| Log((IR(i)/IC(i))+Ip-(i*inc+Vmin)Rp/|z|)-log(IE) | |
| = ((i*inc+Vmin)-Vmax)/TE | line 15 |
| Solve | line 16 |
| II(i)/IC(i) = (i*inc+Vmin)/{C(i)* omega*|z|} | |
| To obtain B = 1/{C(i)* omega*|z|} | line 17 |
| Solve | line 18 |
| |z| = 1/(A^2 + B^2) | line 19 |
| Using value for |z| obtain Rp from A | line 20 |
| Using value for |z| obtain C from B for each v' | line 21 |
| Solve | line 22 |
| C(v') = εA/7411 √{Ne/(v'-Vp)} | |
| To obtain value for Ne and Vp | line 23 |

Remarks:

Line 1: 1 volt per increment in rank

Line 5: converts measured voltage v(t) into the corresponding rank i. So for Vmin = -50 and Vmax = +50, i will range from 0 to 100. For Vmin = -20 and Vmax = +20 with inc = 0.2 (i.e. rank interval = 0.2 volts), i will range from 0 to 200

Line 6: IR is real transfer function. The value of each current measurement I(t) is added to a cumulative aggregate total of all of the current values measured for voltages v(t) falling within the same rank i. Each rank i therefore has its own associated cumulative total IR(i).

Line 7: increments a count register for that rank.

Line 8:    II is the imaginary transfer function, and for each measurement I(t) the expression $Sqrt([I(v')-\Sigma I(v')/n]^2)$ is evaluated and added to a cumulative register II(i) for the associated voltage rank, for use in later calculations.

Line 9:    calculating the thermal electron current Ie(vmax) as the difference between the current I(vmax) measured at a maximum voltage value vmax, and the current I(vmin) measured at a minimum voltage value vmin.

Line 10:    for v(t) < 0

Line 12:    equivalent to the equation $\Sigma I(v')/n = -Ip + v'Rp/|z|$, which can be solved for the intercept -Ip and the slope Rp/|z|.

Line 13:    for v(t) > 0

Line 15:    equivalent to the equation $log_e(\Sigma I(v')/n + Ip - v'Rp/|z|) - log_e(Ie(v_{max})) = (v'-v_{max})/Te$, which can be solved for Te

Line 17    equivalent to the equation $Sqrt([I(v')-\Sigma I(v')/n]^2) = \omega v'/\{C(v')\omega^2|z|\}$

The present invention solves the equations by means of an averaging technique that is much less sensitive to noise and can measure Rp, Te and Vp. It thus overcomes the drawbacks of the current art and can measure the ion flux, and other key plasma parameters on any RF biased electrode including the substrate. The technique can measure the ion flux to an RF biased substrate or surface without the need for a special probe to be mounted in the chamber. The technique can also use the existing RF bias which may already be present. Further the technique does not need to pulse on and off an RF but can measure the ion flux directly even when the RF is continuously applied to a capacitive-coupled electrode.

The technique meets the needs of plasma systems to measure ion flux and electron temperature on the RF biased substrate or electrode and is a simpler and less expensive way than the known art. The technique is versatile and can provide a powerful diagnostics of a wide range of plasma chambers. The technique also allows the measurement of other key parameters such as effective plasma resistance which is linked to the effective electron collision frequency. The technique can determine electron density and plasma potential. In this regard the technique is more versatile than a Langmuir probe which is the standard technique used in research reactors but not suitable to process reactors.

## Harmonic analysis

A similar approach using the real components of Fourier transforms of current and voltage can also achieve similar results. An important conclusion disclosed here is that the magnitude of the real component of current to the electrode is approximately equal to the ion flux for cases where V Rp < IonFlux. Furthermore, where the amplitude of V >> KTe, then the real component of the first harmonic also approaches the amplitude of the ion flux even when V Rp > IonFlux.

If one takes the real current-voltage characteristics and then notes, where the amplitude of v' greatly exceeds the electron temperature expressed in units of voltage, the electron current approaches a delta function about $v_{max}$, we can now remove the electrons in voltage space, as described above, by staying at negative voltages (away from $v_{max}$), or in Fourier space by noting the properties of a delta function in time. The key is to use the delta function to eliminate the electrons.

In a voltage-current transfer function we express the current as a function of voltage rather than time:

$$I(v(t)) = -Ip + R/|z| * v(t) + Ie(v_{max})Exp((v(t)- v_{max})/Te) + dv(t))/dt /\{C(t)\omega^2|z|\}$$

For simplicity we assume v(t) has the form $v_{max} \, sin(wt)$. The real voltage-current transfer function will be of the form

$$Real(I(v(t)) \quad = -Ip + R/|z| \; v_{max} \, cos(wt) + Ie(v_{max})Exp((v_{max} \, sin(wt) - v_{max})/Te)$$

In the limit $v_{max}/Te>>1$ the term on the right tends towards a delta function centered on $v_{max}$ so that this term is effectively zero when cos(wt) is negative, that is during the negative half cycle of the voltage. It also means that the Fourier cosine components of $+Ie(v_{max})Exp((v_{max}sin(wt) - v_{max})/Te)$ tend towards a constant, C1, including the DC component. Because we have a dielectric layer then the dc component is zero and by definition Ip=C1. A more formal mathematical derivation follows:

The real and imaginary current-voltage transfer functions are expressed in terms of current as a function of voltage. We express the current as a function of the time independent voltage value v'. But v' can also be expressed as a function of time. In the case of the real current-voltage transfer function this is expressed as v' = vmax cos(ωt). In the case of the imaginary current-voltage transfer function it is expressed as v' = vmax sin(ωt).

It is also possible to replace the analysis by using Fourier analysis. Fc is the Fourier Cosine Transform and extracts the real component of the function. In many practical applications it is possible to assume that the voltage is a sinusoidal signal with amplitude V0. We also note that vmax = V0 by definition. Then:

$$Fr(v') = \ Fr(V0\ \cos(\omega t)) = \ A0 + A1\cos(\omega t) + A2\cos(2\omega t) +\dots \qquad \textbf{Eq. 6}$$

Where Fr represents the real component of the Fourier transform.

$$Fr(v') = -Ip + R/|z| * v' + Ie(vmax)Exp((v(t) - vmax)/Te) \quad \dots [\text{from Eq. 2}]$$

$$Fr(v') \ = -Ip + R/|z| * V0\ \cos(\omega t) + Ie(V0)Exp((V0\ \cos(\omega t) - V0)/Te) \qquad \textbf{Eq. 7}$$

FromEqs. 6 & 7:

$$A0 + A1*\cos(\omega t) + A2\cos(2\omega t) +\dots$$
$$= -Ip + R/|z| * V0*\cos(\omega t) + Ie(vmax)Exp((V0*\cos(\omega t) - vmax)/Te) \qquad \textbf{Eq. 8}$$

This equation is now a function of time. Taking the fourier cosine transform of Eqs. 6 and 8 and measuring a number of real current harmonics allows us to solve for Ip and other parameters.

In the vast majority of plasmas, V0/Te will exceed 10 and so the approximation $V0/Te \rightarrow \infty$ is valid, at least for the first few harmonic components. In the limit of $V0/Te \rightarrow \infty$, the exponential term approaches a delta function at V0. Then the Fourier Transform of the exponential term is just a constant C1 at all frequencies.

$$A0 = -Ip + C1$$

$$A1 = R/|z| * V0 + C1$$

$$A2 = C1; A3 = C1; \dots An = C1\ (for\ n>=2)$$

A0 is the direct current term and as there is a dielectric blocking the DC this means that A0 must be zero, then C1 = Ip. We can now measure the amplitudes associated with the first order and second order terms, A1 and A2, and solve for C1, Ip and the resistive term R/|z|.

**Claims**

1. A method of measuring ion current between a plasma and an electrode in communication with said plasma, wherein a time-varying voltage is measured at said electrode and a time-varying current through said electrode is measured, the method comprising the steps of:

   (a) recording, for each of a plurality of voltage values, *v'*, a plurality, *n,* of current values I(v'); and
   (b) obtaining from said current and voltage values a value of said ion current; wherein:

   said electrode is insulated from said plasma by an insulating layer, such that said current values lack a DC component; and
   said step of obtaining a value of said ion current comprises performing a mathematical transform effective to:

   (i) express said current and voltage values as a relationship between the real component of current through said electrode and the voltage by obtaining an average of the current values measured for each of a plurality of discrete voltage values, thereby eliminating a capacitive contribution to the current through the electrode;
   (ii) isolating from said real component of current through the electrode an isolated contribution attributable to an ion current and a resistive term, said contribution being free of any electron current contribution; and

(iii) determining from said isolated contribution a value of ion current.

2. A method as claimed in claim 1, wherein said step of isolating a contribution attributable only to ion current and a resistive term comprises determining a threshold voltage below which electron current is inhibited, and isolating a set of current values corresponding to a set of voltage values below said threshold.

3. A method as claimed in 2, wherein said step of determining from said isolated contribution a value for the ion current, Ip, comprises solving, for values of v' less than said threshold, the equation:

$$\Sigma\ I(v')\ /\ n = -Ip\ +\ v'\,Rp/\,|z|\ ,$$

where:
Rp is the plasma resistance,

$$|z| = \{\,Rp^2\ +\ (1/\,\omega C(t))^{\,2}\,\},$$

$\omega = 2\pi f$, where f is the frequency of the RF voltage on the electrode, and
C(t) is the time-dependent capacitive component of the plasma impedance.

4. A method according to claim 3, further comprising the step of calculating the resistive term $Rp/|z|$ as a solution to the same equation: $\Sigma I(v')/n = -Ip + v'Rp/|z|$.

5. A method as claimed in any preceding claim, wherein said time-varying voltage is a sinusoidal voltage applied to said electrode.

6. A method as claimed in any preceding claim, wherein said plurality, $n,$ of current values $I(v')$ measured for each of a plurality of voltage values, $v',$ include approximately $n/2$ values measured where the voltage is increasing and approximately $n/2$ values measured where the voltage is decreasing.

7. A method as claimed in claim 6, wherein said voltage is a periodically varying voltage and said current values $I(v')$ are measured at times which are uncorrelated with the period of the voltage.

8. A method as claimed in claim 3 or any claim dependent thereon, further comprising the steps of:

(d) calculating the thermal electron current at vmax, Ie(vmax) as the difference between the average current $\Sigma I(vmax)/n$ measured at a maximum voltage value vmax, and the current extrapolated from the linear equation for current as a function of v', for v' <0, in accordance with the equation:

$$Ie(vmax) = (\Sigma\ I(vmax)/n + Ip -\ vmax\ Rp/|z|);$$

and
(e) calculating, for values of v' > 0, the electron temperature Te from the equation:

$$(\Sigma\ I(v')\ /\ n + Ip -\ v'\ Rp/|z|\ )\ /\ Ie(v_{max})\ = Exp((v'- v_{max}\ )/Te).$$

9. A method as claimed in claim 3 or any claim dependent thereon, further comprising the step of:
determining, from the equation $Sqrt([I(v')-\Sigma I(v')/n]^2) = \omega v'/\{C(v')\omega^2|z|\}$, the voltage-dependent capacitance, C(v').

10. A method as claimed in claim 9, further comprising the step of solving the equation:

$$C(t) = \varepsilon A/7411\ \sqrt{\{Ne/(v(t)-Vp)\}}$$

to obtain the electron density, Ne, and the plasma potential, Vp, where A is the electrode area and $\varepsilon$ is the permittivity of free space, in MKS units.

11. A method as claimed in claim 1, wherein said step of expressing said current and voltage values comprises performing a Fourier transform to obtain a series of Fourier components representing the real electrode current.

12. A method as claimed in claim 11, wherein said step of isolating a contribution attributable only to ion current and a resistive term comprises identifying within said series of Fourier components one or more components attributable only to an electron current and subtracting said one or more electron current components to leave a remainder attributable only to ion current and a resistive term.

13. A method as claimed in claim 11 or 12, wherein said step of determining from said isolated contribution a value for the ion current, Ip, comprises solving the equation for A0, the zeroth order Real Fourier coefficient: A0 = C1 - Ip = 0, where C1 is the magnitude of the second order Real Fourier coefficient.

14. A computer program product comprising a data carrier having recorded thereon instructions which when executed by a processor are effective to cause said processor to calculate an ion current between a plasma and an electrode insulated from said plasma by an insulating layer, wherein a time-varying voltage is applied to said electrode and a time-varying current through said insulating layer is measured, the instructions when executed causing said processor to carry out the method of any of claims 1 to 13.

15. An apparatus adapted to measure ion current between a plasma and an electrode insulated from said plasma by an insulating layer, comprising:

   (a) a voltage source adapted to apply a time-varying voltage to said electrode
   (b) a current meter adapted to measure a time-varying current through said insulating layer such that for each of a plurality of voltage values, v', a plurality, n, of current values I(v') are measured at different times;
   (c) a processor programmed adapted calculate a value for the ion current, by performing a mathematical transform effective to:

      (i) express said current and voltage values as a relationship between the real component of current through said electrode and the voltage by obtaining an average of the current values measured for each of a plurality of discrete voltage values, thereby eliminating a capacitive contribution to the current through the electrode;
      (ii) isolate from said real component of current through the electrode an isolated contribution attributable to an ion current and a resistive term, said contribution being free of any electron current contribution; and
      (iii) determine from said isolated contribution a value of ion current.

**Patentansprüche**

1. Verfahren zum Messen von Ionenstrom zwischen einem Plasma und einer Elektrode in Kommunikation mit dem Plasma, wobei eine zeitvariierende Spannung an der Elektrode gemessen wird und ein zeitvariierender Strom durch die Elektrode gemessen wird, wobei das Verfahren die folgenden Schritte umfasst:

   (a) Aufzeichnen für jeden einer Vielzahl von Spannungswerten, v', einer Vielzahl, n, von Stromwerten I(v'); und
   (b) Erhalten eines Werts des Ionenstroms aus den Strom- und Spannungswerten;

   wobei:

   die Elektrode von dem Plasma durch eine Isolierschicht isoliert ist, sodass den Stromwerten eine DC-Komponente fehlt; und
   der Schritt des Erhaltens eines Werts von Ionenstrom Durchführen einer mathematischen Transformation umfasst, die zu Folgendem wirksam ist:

      (i) Ausdrücken der Strom- und Spannungswerte als ein Verhältnis zwischen der realen Komponente des Stroms durch die Elektrode und der Spannung durch Erhalten eines Durchschnitts der Stromwerte, die für jeden einer Vielzahl von diskreten Spannungswerten gemessen sind, wodurch ein kapazitiver Beitrag zu dem Strom durch die Elektrode entfernt wird;

(ii) Isolieren eines isolierten Beitrags, der einem Ionenstrom und einem Widerstandsterm zugeordnet werden kann, von der realen Komponente des Stroms durch die Elektrode, wobei der Beitrag frei von beliebigem Elektronenstrombeitrag ist; und

(iii) Bestimmen eines Werts von Ionenstrom aus dem isolierten Beitrag.

2. Verfahren nach Anspruch 1, wobei der Schritt des Isolierens eines Beitrags, der nur dem Ionenstrom und einem Widerstandsterm zugeordnet werden kann, Bestimmen einer Schwellenwertspannung, unter welcher der Elektronenstrom eingeschränkt ist, und Isolieren einer Reihe von Stromwerten, die einer Reihe von Spannungswerten unter dem Schwellenwert entsprechen, umfasst.

3. Verfahren nach Anspruch 2, wobei der Schritt des Bestimmens eines Werts für den Ionenstrom, Ip, aus dem isolierten Beitrag Lösen der folgenden Gleichung nach den Werten für v', die unter dem Schwellenwert liegen, umfasst:

$$\Sigma\, I(v') \,/\, n = -Ip + v'\, Rp / |z| \, ,$$

wobei:
Rp der Plasmawiderstand ist,

$$|z| = \{ Rp^2 + (1/\omega C(t))^2 \},$$

$\varpi = 2\pi f$, wobei f die Frequenz der Funkfrequenz-(RF-) Spannung an der Elektrode ist und C(t) die zeitabhängige kapazitive Komponente der Plasmaimpedanz ist.

4. Verfahren nach Anspruch 3, das ferner den Schritt des Berechnens des Widerstandsterms Rp/|z| als eine Lösung derselben Gleichung $\Sigma I(v')'/n = -Ip + v'Rp/|z|$ umfasst.

5. Verfahren nach einem der vorhergehenden Ansprüche, wobei die zeitvariierende Spannung eine sinusförmige Spannung ist, die auf die Elektrode angewendet wird.

6. Verfahren nach einem der vorhergehenden Ansprüche, wobei die Vielzahl, *n,* von Stromwerten I(v'), die für jeden einer Vielzahl von Spannungswerten, *v',* gemessen werden, ungefähr *n/2* Werte, die gemessen werden, wo die Spannung steigt, und ungefähr *n/2* Werte beinhaltet, die gemessen werden, wo die Spannung abfällt.

7. Verfahren nach Anspruch 6, wobei die Spannung eine von Zeit zu Zeit variierende Spannung ist und die Stromwerte I(v') zu Zeitpunkten gemessen werden, die nicht mit dem Zeitraum der Spannung korrelieren.

8. Verfahren nach Anspruch 3 oder einem davon abhängigen Anspruch, das ferner die folgenden Schritte umfasst:

(d) Berechnen des thermischen Elektronenstroms bei vmax, Ie(vmax) als der Unterschied zwischen dem durchschnittlichen Strom $\Sigma I(vmax)/n$, gemessen an einem Höchstspannungswert vmax und des Stroms, der aus der linearen Gleichung für Strom als eine Funktion von v' für v'<0 gemäß der folgenden Gleichung extrapoliert ist:

$$Ie(vmax) = (\Sigma\, I(vmax)/n + Ip - vmax\, Rp/|z|) \, ;$$

und
(e) Berechnen der Elektronentemperatur Te für Werte von v'>0 aus der folgenden Gleichung:

$$(\Sigma\, I(v') \,/\, n + Ip - v'\, Rp/|z| \,) \,/\, Ie(v_{max}) = Exp((v' - v_{max})/Te).$$

9. Verfahren nach Anspruch 3 oder einem davon abhängigen Anspruch, das ferner den folgenden Schritt umfasst: Bestimmen der spannungsabhängigen Kapazitanz, C(v'), aus der Gleichung $Sqrt([I(v') - \Sigma(v')/n]^2) = \omega v'/\{C(v')\,\omega^2 |z|\}$.

10. Verfahren nach Anspruch 9, das ferner den Schritt des Lösens der folgenden Gleichung umfasst:

$$C(t) = \varepsilon A/7411 \sqrt{\{Ne/(v(t)-Vp)\}} \ ,$$

um die Elektronendichte, Ne, und das Plasmapotential, Vp, zu erhalten, wobei A der Elektrodenbereich ist und ε die Permittivität des freien Raums in MKS-Einheiten ist.

11. Verfahren nach Anspruch 1, wobei der Schritt des Ausdrückens der Strom- und Spannungswerte Durchführen einer Fourier-Transformation umfasst, um eine Reihe von Fourier-Komponenten zu erhalten, die den realen Elektrodenstrom darstellen.

12. Verfahren nach Anspruch 11, wobei der Schritt des Isolierens eines Beitrags, der nur dem Ionenstrom und einem Widerstandsterm zugeordnet werden kann, Identifizieren von einer oder mehreren Komponenten innerhalb der Reihe von Fourier-Komponenten, die nur einem Elektronenstrom zugeordnet werden können, und Subtrahieren der einen oder mehreren Elektronenstromkomponenten, damit ein Rest verbleibt, der nur dem Ionenstrom und einem Widerstandsterm zugeordnet werden kann, umfasst.

13. Verfahren nach Anspruch 11 oder 12, wobei der Schritt des Bestimmens eines Werts für den Ionenstrom, Ip, aus dem isolierten Beitrag Lösen der Gleichung nach A0, des Real-Fourier-Koeffizienten der nullten Ordnung umfasst: A0 = C1 -Ip = 0, wobei C1 die Größe des Real-Fourier-Koeffizienten der zweiten Ordnung ist.

14. Computerprogrammprodukt, das einen Datenträger umfasst, der Anweisungen darauf aufgenommen aufweist, die, wenn sie durch einen Prozessor ausgeführt werden, dazu wirksam sind, den Prozessor dazu zu veranlassen, einen Ionenstrom zwischen einem Plasma und einer Elektrode, die durch eine Isolationsschicht von dem Plasma isoliert ist, zu berechnen, wobei eine zeitvariierende Spannung auf die Elektrode aufgebracht und ein zeitvariierender Strom durch die Isolationsschicht gemessen wird, wobei die Anweisungen, wenn sie ausgeführt werden, den Prozessor dazu veranlassen, das Verfahren nach einem der Ansprüche 1 bis 13 auszuführen.

15. Vorrichtung, die zum Messen eines Ionenstroms zwischen einem Plasma und einer Elektrode ausgestaltet ist, die durch eine Isolationsschicht von dem Plasma isoliert ist, die Folgendes umfasst:

(a) eine Spannungsquelle, die dazu ausgestaltet ist, eine zeitvariierende Spannung auf die Elektrode aufzubringen

(b) ein Spannungsmessgerät, das dazu ausgestaltet ist, einen zeitvariierenden Strom derart durch die Isolationsschicht zu messen, dass für jeden einer Vielzahl von Spannungswerten, *v'*, eine Vielzahl, *n,* von Stromwerten I(v') an unterschiedlichen Zeitpunkten gemessen wird;

(c) einen Prozessor, der dazu programmiert ausgestaltet ist, einen Wert für den Ionenstrom durch Durchführen einer mathematischen Transformation zu berechnen, die zu Folgendem wirksam ist:

(i) Ausdrücken der Strom- und Spannungswerte als ein Verhältnis zwischen der realen Komponente des Stroms durch die Elektrode und der Spannung durch Erhalten eines Durchschnitts der Stromwerte, die für jeden einer Vielzahl von Spannungswerten gemessen sind, wodurch ein kapazitiver Beitrag zu dem Strom durch die Elektrode entfernt wird;

(ii) Isolieren eines isolierten Beitrags aus der realen Komponenten von Strom durch die Elektrode, der einem Ionenstrom und einem Widerstandsterm zugeordnet werden kann, wobei der Beitrag frei von beliebigem Elektronenstrombeitrag ist; und

(iii) Bestimmen eines Werts von Ionenstrom aus dem isolierten Beitrag.

## Revendications

1. Procédé de mesure d'un courant ionique entre un plasma et une électrode en communication avec ledit plasma, dans lequel une tension variable dans le temps est mesurée sur ladite électrode et un courant variable dans le temps traversant ladite électrode est mesuré, le procédé comprenant les étapes suivantes :

(a) enregistrement, pour chacune d'une pluralité de valeurs de tension, *v'*, d'une pluralité, *n,* de valeurs de courant I(v') ; et

(b) obtention à partir desdites valeurs de courant et de tension d'une valeur dudit courant ionique ; dans lequel :

ladite électrode est isolée dudit plasma par une couche isolante, de sorte que lesdites valeurs de courant ne comportent pas de composante CC ; et

ladite étape d'obtention d'une valeur dudit courant ionique comprend la réalisation d'une transformée mathématique servant à :

(i) exprimer lesdites valeurs de courant et de tension en tant que relation entre la composante réelle de courant traversant ladite électrode et la tension en obtenant une moyenne des valeurs de courant mesurées pour chacune d'une pluralité de valeurs de tension discrètes, éliminant ainsi une contribution capacitive au courant traversant l'électrode ;

(ii) isoler de ladite composante réelle du courant traversant l'électrode une contribution isolée attribuable à un courant ionique et un terme résistif, ladite contribution étant exempte de toute contribution de courant électronique ; et

(iii) déterminer à partir de ladite contribution isolée une valeur de courant ionique.

2. Procédé selon la revendication 1, dans lequel ladite étape d'isolation d'une contribution attribuable uniquement au courant ionique et d'un terme résistif comprend la détermination d'une tension de seuil en dessous de laquelle le courant électronique est inhibé, et l'isolation d'un ensemble de valeurs de courant correspondant à un ensemble de valeurs de tension en dessous dudit seuil.

3. Procédé selon la revendication 2, dans lequel ladite étape de détermination à partir de ladite contribution isolée d'une valeur pour le courant ionique, Ip, comprend la résolution, pour des valeurs de v' inférieures audit seuil, de l'équation :

$$\sum I(v') \, / \, n = - \, Ip + \quad v' \, Rp \, / \, |z| \, ,$$

où :
Rp est la résistance du plasma,

$$|z| = \left\{ Rp^2 + (1/\omega C(t))^2 \right\},$$

$\omega = 2\pi f$, où f est la fréquence de la tension RF sur l'électrode, et
C(t) est la composante capacitive en fonction du temps de l'impédance du plasma.

4. Procédé selon la revendication 3, comprenant en outre l'étape de calcul du terme résistif Rp/|z| en tant que solution de la même équation : $\sum I(v')/n = -Ip + v'Rp/|z|$.

5. Procédé selon l'une quelconque des revendications précédentes, dans lequel ladite tension variable dans le temps est une tension sinusoïdale appliquée à ladite électrode.

6. Procédé selon l'une quelconque des revendications précédentes, dans lequel ladite pluralité, *n,* de valeurs de courant I(v') mesurées pour chacune d'une pluralité de valeurs de tension, *v',* inclut approximativement *n/2* valeurs mesurées lorsque la tension augmente et approximativement *n/2* valeurs mesurées lorsque la tension diminue.

7. Procédé selon la revendication 6, dans lequel ladite tension est une tension variant périodiquement et lesdites valeurs de courant I(v') sont mesurées à des moments qui sont sans corrélation avec la période de la tension.

8. Procédé selon la revendication 3 ou selon une quelconque revendication dépendante de celle-ci, comprenant en outre les étapes de :

(d) calcul du courant électronique thermique à vmax, Ie(vmax) en tant que différence entre le courant moyen $\sum I(vmax)/n$ mesuré à une valeur de tension maximale vmax, et le courant extrapolé à partir de l'équation linéaire du courant en fonction de v', pour v' < 0, selon l'équation :

$$Ie(v\max) = (\Sigma \quad I(v\max)/n + Ip - v\max \, Rp / |z|) \quad ;$$

et

(e) calcul, pour les valeurs de v' > 0, de la température électronique Te à partir de l'équation :

$$(\Sigma \, I(v') \, / \, n + Ip - v' \, Rp \, / |z|) \, / \, Ie \, (v_{max}) = Exp((v' - v_{max}) / Te).$$

**9.** Procédé selon la revendication 3 ou une quelconque revendication dépendante de celle-ci, comprenant en outre l'étape de :

détermination, à partir de l'équation $Sqrt([I(v') - \Sigma I(v')/n]^2) = \omega v'/\{C(v')\omega^2|z|\}$, de la capacitance dépendante de la tension, C(v').

**10.** Procédé selon la revendication 9, comprenant en outre l'étape de résolution de l'équation :

$$C(t) = \varepsilon A / 7411 \sqrt{\{Ne/(v(t) - Vp)\}}$$

pour obtenir la densité électronique, Ne, et le potentiel du plasma, Vp, où A est la surface d'électrode et $\varepsilon$ est la permittivité de l'espace libre, en unités MKS.

**11.** Procédé selon la revendication 1, dans lequel ladite étape d'expression desdites valeurs de courant et de tension comprend la réalisation d'une transformée de Fourier pour obtenir une série de composantes de Fourier représentant le courant d'électrode réel.

**12.** Procédé selon la revendication 11, dans lequel ladite étape d'isolation d'une contribution attribuable uniquement au courant ionique et d'un terme résistif comprend l'identification au sein de ladite série de composantes de Fourier d'une ou plusieurs composantes attribuables uniquement à un courant électronique et la soustraction desdites une ou plusieurs composantes de courant électronique pour laisser un reste attribuable uniquement à un courant ionique et un terme de résistance.

**13.** Procédé selon la revendication 11 ou 12, dans lequel ladite étape de détermination à partir de ladite contribution isolée d'une valeur pour le courant ionique, Ip, comprend la résolution de l'équation pour A0, le coefficient de Fourier réel d'ordre zéro : A0 = C1 - Ip = 0, où C1 est la grandeur du coefficient de Fourier réel de second ordre.

**14.** Produit de programme informatique comprenant un support de données sur lequel sont enregistrées des instructions qui lorsqu'elles sont exécutées par un processeur servent à amener ledit processeur à calculer un courant ionique entre un plasma et une électrode isolée dudit plasma par une couche isolante, dans lequel une tension variable dans le temps est appliquée à ladite électrode et un courant variable dans le temps traversant ladite couche isolante est mesuré, les instructions lorsqu'elles sont exécutées amenant ledit processeur à réaliser le procédé selon l'une quelconque des revendications 1 à 13.

**15.** Appareil adapté pour mesurer un courant ionique entre un plasma et une électrode isolée dudit plasma par une couche isolante, comprenant :

(a) une source de tension adaptée pour appliquer une tension variable dans le temps à ladite électrode

(b) un courantomètre adapté pour mesurer un courant variable dans le temps traversant ladite couche isolante de sorte que pour chacune d'une pluralité de valeurs de tension, v', une pluralité, n, de valeurs de courant I(v') sont mesurées à des moments différents ;

(c) un processeur programmé adapté pour calculer une valeur du courant ionique, en effectuant une transformée mathématique servant à :

(i) exprimer lesdites valeurs de courant et de tension en tant que relation entre la composante réelle de courant traversant ladite électrode et la tension en obtenant une moyenne des valeurs de courant mesurées pour chacune d'une pluralité de valeurs de tension discrètes, éliminant ainsi une contribution à la capacité du courant traversant l'électrode ;

(ii) isoler de ladite composante réelle de courant traversant l'électrode une contribution isolée attribuable à un courant ionique et un terme résistif, ladite contribution étant exempte de toute contribution de courant électronique ; et

(iii) déterminer à partir de ladite contribution isolée une valeur de courant ionique.

Fig. 1

$t_1 = \pi / \omega + \delta$

$t_2 = 2\pi / \omega + \delta$

$t_3 = 3\pi / \omega + \delta$

$t_4 = 4\pi / \omega + \delta$

Fig. 2

Fig. 3

V(t)          I(t)

Fig. 4

Fig. 5

Fig. 6

Fig. 7

## Real Current-Voltage Transfer Function

$$\Sigma\ I(v') / n$$

# Fig. 8

## Imaginary Voltage-Current Transfer Function
$$Sqrt([\ I\ (v')-\Sigma\ I(v') / n\ ]^{2})$$

$v'$

# Fig. 9

## REFERENCES CITED IN THE DESCRIPTION

**Patent documents cited in the description**

- US 5936413 A
- US 6326794 B
- US 6339297 B

**Non-patent literature cited in the description**

- **M.B. HOPKINS.** Langmuir Probe Measurements in the Gaseous Electronics Conference RF Reference Cell. *J. Res. Natl. Inst. Stand. Technol.,* 1995, vol. 100, 415
- Retarding Field Energy Analyser, described in Design of Retarding Field Energy Analyzers. *J. Arol Simpson, Rev. Sci. Instrum.,* 1961, vol. 32, 1283
- **M. A. SOBOLEWSKI.** Measuring the ion current in electrical discharges using radio-frequency, current and voltage measurements. *Appl. Phys. Lett.,* 09 March 1998, vol. 72 (10